Europäisches Patentamt

European Patent Office

Office européen des brevets

(11) Veröffentlichungsnummer: **0 247 399 B1**

# (12) EUROPÄISCHE PATENTSCHRIFT

(45) Veröffentlichungstag der Patentschrift: **12.06.91**

(51) Int. Cl.⁵: **H03F 1/52**, H03F 1/30

(21) Anmeldenummer: **87106546.2**

(22) Anmeldetag: **06.05.87**

(54) **Schaltungsanordnung zum Schutz vor Überlastung einer Gegentaktendstufe.**

(30) Priorität: **23.05.86 DE 3617476**
**20.09.86 DE 3632077**

(43) Veröffentlichungstag der Anmeldung:
**02.12.87 Patentblatt 87/49**

(45) Bekanntmachung des Hinweises auf die
Patenterteilung:
**12.06.91 Patentblatt 91/24**

(84) Benannte Vertragsstaaten:
**AT BE CH DE ES FR GB IT LI LU NL SE**

(56) Entgegenhaltungen:
**DE-A- 2 629 497**
**DE-A- 3 150 371**
**FR-A- 2 237 342**
**GB-A- 2 069 272**
**US-A- 4 356 452**

(73) Patentinhaber: **Deutsche Thomson-Brandt GmbH**
**Hermann-Schwer-Strasse 3 Postfach 1307**
**W-7730 Villingen-Schwenningen(DE)**

(72) Erfinder: **Schmitz, Friedrich**
**Sebastian-Kneipp-Strasse 24**
**W-7730 Villingen-Schwenningen(DE)**

**Beschreibung**

Die Erfindung geht aus einer Schaltungsanordnung zum Schutz vor überlastung einer transistorisierten Gegentaktendstufe, an deren Ausgang eine Lastimpedanz nach Bezugspotential geschaltet ist, wobei in jedem Zweig der Gegentaktendstufe ein Fühlelement zur Messung des in der Gegentaktendstufe fliessenden Ausgangsstromes vorgesehen ist.

Eine Schaltung zum Schutz gegen überlastung einer Endstufe ist z.B. beschrieben in der DE-A- 33 11 955. Dort wird über einen Fühlwiderstand in der Endstufe eine dem Ausgangsstrom proportionale Spannung abgenommen, die bei überschreiten eines vorgegebenen Ausgangsstromes über eine Meß- und Schalteinrichtung die Endstufe außer Betrieb setzt. Die gezeigte Schaltung wertet dabei nur eine Hälfte des Ausgangsstromes aus. Diese Schaltung arbeitet deshalb nicht genau genug und ist für hochwertige Endstufen z.B. in Hifi-Anlagen ungeeignet. Außerdem besitzt die bekannte Schaltung erhebliche Toleranzen, so daß ein definierter Abschaltpunkt der Endstufe nicht erreichbar ist.

Dies ist auch der Fall bei einer in der GB-A-2 069 272 gezeigten Schaltung, bei welcher über einen Sensorwiderstand, der in einer Endstufe fliessende Strom gemessen wird, wobei bei überschreiben eines Grenzwertes über einen elektronischen Schalter das Eingangssignal für die Endstufe unterbrochen wird.

In einer in der DE-A-26 29 497 gezeigten Schutzschaltung für eine Endstufe sind zwar zwei Fühlwiderstände für den in dieser fliessenden Strom vorgesehen. Hier werden die an den Fühlwiderständen abgegriffenen Spannungen aber nicht auf das Potential bezogen, auf das die Lastimpedanz arbeitet. Die an den Fühlwiderständen abgegriffenen Spannungen werden hier summiert und über einen übertrager an eine Doppelweggleichrichterschaltung gelegt. Der übertrager stellt aber ein teueres Bauteil dar und ist auch nicht frequenzunabhängig, so daß die Schutzschaltung nicht für einen großen Frequenzbereich linear arbeitet, wie es für Endstufen für den Audiobereich wichtig ist. Die bekannte Schaltung sieht vor, daß der vor der Endstufe angeordnete Vorverstärker in seiner Verstärkung auf zwei definierte Werte umgeschaltet wird. Eine Abschaltung der Endstufe ist nicht vorgesehen.

Der Erfindung liegt die Aufgabe zugrunde eine genau definierte Abschaltung der Endstufe bei überlastung zu erreichen. Diese Aufgabe wird gemäß der Erfindung durch die im Patentanspruch 1 aufgeführten Merkmale gelöst. Weitere Ausgestaltungen der Erfindung ergeben sich aus den Unteransprüchen.

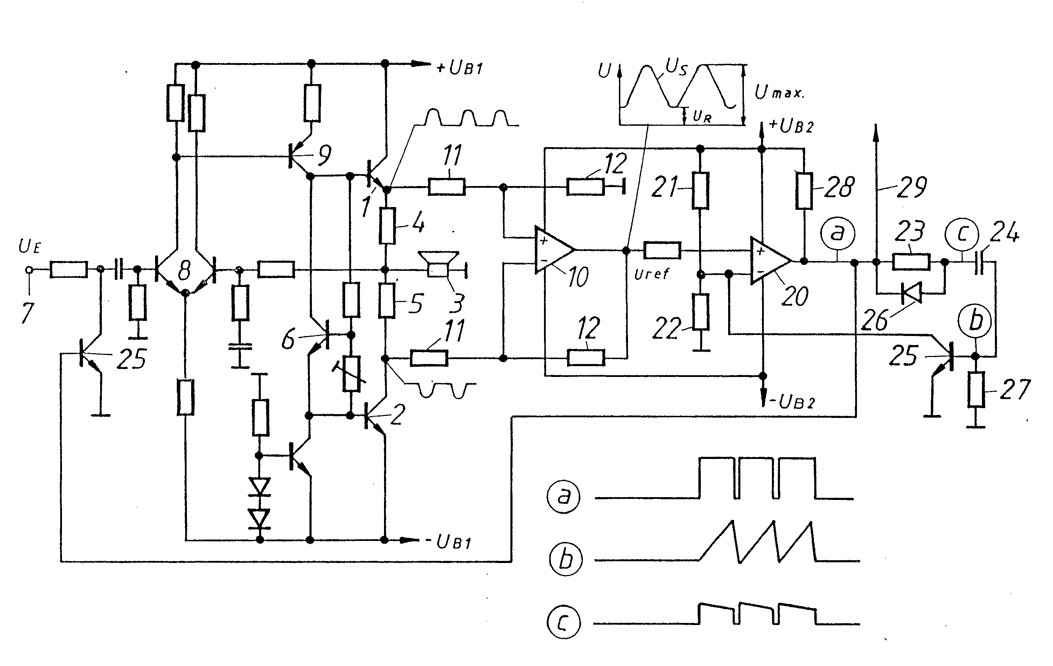

Nachstehend wird die Erfindung mit Hilfe der Zeichnung an einem Ausführungsbeispiel beschrieben.

Es handelt sich bei der Schaltungsanordnung um den Aufbau einer bekannten Gegentaktendstufe mit den komplementären mit ihren Emittern zusammengeschalteten Endtransistoren 1 und 2, deren Kollektoren mit dem Betriebsspannungspotential +UB1 bzw. -UB1 verbunden sind. Die Lastimpedanz 3, z.B. in Form eines Lautsprechers, ist an den Ausgang der Gegentaktendstufe angeschlossen. Das andere Ende der Lastimpedanz ist mit einem Bezugspotential z.B. Masse verbunden. Zwecks Messung des in der Gegentaktendstufe fliessenden Ruhestromes sind in die Emitterleitungen je ein Widerstand 4 bzw. 5 eingeschaltet. Zwecks Einstellung des Ruhestromes dient ein zwischen die Basen der Endtransistoren 1 und 2 eingeschalteter Transistor 6. Über den Anschluß 7 wird das Eingangssignal UE zugeführt, welches über den Vorverstärker 8 und den Treibertransistor 9 die Gegentaktendstufe ansteuert. An die Widerstände 1 und 5 sind gegen das Bezugspotential gemessene Spannungen abgreifbar. Die an dem Widerstand 4 abgegriffene Spannung, die durch den Ruhestrom und den diesem überlagerten durch sie Lastimpedanz 3 fliessenden Laststrom gebildet wird, wird dem nichtinvertierenden Eingang einer Differenzverstärkerstufe 10 und die am Widerstand 5 abgegriffene Spannung dem invertierenden Eingang der Differenzverstärkerstufe 10 zugeführt.

Am Ausgang der Differenzverstärkerstufe 10 entsteht ein Signal, wie es in der Figur eingezeichnet ist. Es setzt sich zusammen aus dem Wert UR, der dem Ruhestrom, und dem Wert US, der dem Signalstrom entspricht. Durch die Zuführung des negativen Signalanteils an den invertierenden Eingang der Differenzverstärkerstufe 10 erscheint dieser am Ausgang um 180° phasengedreht. Da die Versorgungsspannung UB2 für die Differenzverstärkerstufe 10 meistens kleiner ist als die Versorgungsspannung UB1 für die Gegentaktendstufe, muß die der Differenzverstärkerstufe 10 zugeführte Signalspannung um einen Teilungsfaktor heruntergesetzt werden, der dem Verhältnis der Widerstandswerte der Widerstände $(R11 + R12) / R11$ entspricht. Die Differenzverstärkerstufe 10 besitzt einen Verstärkungsgrad $V = R12/R11$.

Das Ausgangssignal der Differenzverstärkerstufe 10 wird an den Plus-Eingang eines Komparators 20 gelegt, dessen Minus-Eingang auf einem Referenzpotential $U_{ref}$ liegt, welches mit Hilfe des aus den Widerständen 21 und 22 gebildeten Spannungsteilers erzeugt wird, der zwischen die Betriebsspannung +UB2 und Bezugspotential geschaltet ist. Sobald die Ausgangsspannung der Differenzverstärkerstufe 10 dieses Referenzpotential $U_{ref}$ übersteigt, geht der Ausgang des Komparators 20 auf hohes Potential, welches z.B. einen an der Eingang der Gegentaktendstufe angeschlossenen Transistor 25 ansteuert, der das Eingangssignal UE kurzschliesst, wodurch die Überlastung aufgehoben wird. Durch das Verschwinden der Überlastung wird der Transistor 25 sofort wieder gesperrt und es ergibt sich ein getaktetes Ein- und Abschalten der Endstufe. Die Stummsteuerung kann auch an einer anderen Stelle der Schaltung erfolgen, z.B. durch Sperrung des Treibertransistors 9.

Am Ausgang des Komparators 20 liegt demnach im normalen Betriebsfall der Endstufe Bezugspotential an, bei Überlastung dagegen steigt das Potential auf eine durch den wert des mit der Betriebsspannung UB2 verbundenen Widerstandes 23 vorgegebene Größe +Ua. Dieser Potentialsprung wird über den Widerstand 23 und den Kondensator 24 auf die Basis eines Transistors 25 übertragen und bringt diesen in den leitenden Zustand. Dadurch wird der Referenzspannungseingang des Komparators 20 auf Bezugspotential geklemmt, so daß der Ausgang des Komparators mit Sicherheit auf hohem Potential bleibt. Dadurch wird der kondensator 24 aufgeladen und so lange der Transistor 25 durch Ansteuerung seiner Basis leitend gehalten.

Erst wenn der Kondensator 24 aufgeladen ist, sinkt die Basis-Emitterspannung am Widerstand 27 des Transistors 25 soweit ab, daß dieser sperrt und die Referenzspannung $U_{ref}$ am Komparator wieder wirksam wird. Da die Überlast im Moment durch das Mute-Signal nicht mehr vorhanden ist, geht der Komparatorausgang auf Bezugspotential. Dadurch kann sich der Kondensator 24 über die Diode 26 ganz entladen, so daß für einen neuen Zyklus die Anfangsbedingung geschaffen wird.

Liegt der Überlastungsfall noch weiterhin vor, springt der Komparatorausgang sofort wieder auf das +$UB_2$-Potential und der Vorgang wiederholt sich so lange, bis die Überlastung verschwunden ist. Dieser Vorgang ist durch die Diagramme a, b und c in der Figur dargestellt.

Zur Ausschaltung einer im Gegentaktverstärker nicht näher dargestellten und erläuterten Ruhestromregelung kann ein entsprechendes Signal Über die Leitung 29 auf die Ruhestromregelung während der Überlastung des Gegentaktverstärkers einwirken.

## Ansprüche

1. Schaltungsanordnung zum Schutz vor überlastung einer transistorisierten Gegentaktendstufe (1,2), an deren Ausgang eine Lastimpedanz (3) nach Bezugspotential geschaltet ist, wobei in jedem Zweig der Gegentaktendstufe ein Fühlelement (4,5) vorgesehen ist, **dadurch gekennzeichnet,** daß an den Fühlelementen (4, 5) zwei gegen das Bezugspotential gegenphasige Spannungen abgreifbar sind, wobei die gegen das Bezugspotential positiven Spannungen an den nichtinvertierenden Eingang und die gegen das Bezugspotential negativen Spannungen an den invertierenden Eingang einer Differenzverstärkerstufe (10) gelegt sind, und daß der Ausgang der Differenzverstärkerstufe (10) mit dem nichtinvertierenden Eingang (+) einer Komparatorschaltung (20) verbunden ist, an deren invertierenden Eingang (-) eine gegen das Bezugspotential gebildete Referenzspannung (Uref) gelegt ist, und daß bei überschreiten des Referenzpotentials (Uref) am nichtinvertierenden Eingang (+) der Komparatorschaltung (20) an deren Ausgang ein Signal zum Sperren der Gegentaktendstufe (1, 2) abnehmbar ist, bei deren überlastung das Ausgangssignal der Komparatorschaltung (20) über ein Zeitglied (23, 24, 27) und einen von diesen gesteuerten elektronischen Schalter (25) den invertierenden Eingang (-) der Komparatorschaltung (20) auf das Bezugspotential schaltet, und das Ausgangssignal der Komparatorschaltung (20) an den Eingang der Gegentaktendstufe (1, 2) gelegt ist.

2. Schaltungsanordnung nach Anspruch 1, **dadurch gekennzeichnet,** daß das Zeitglied aus einer zwischen den Ausgang der Komparatorschaltung (20) und der Steuerelektrode des elektronischen Schalters (25) liegenden Reihenschaltung eines Widerstands (23) mit einem Kondensator (24) und einem zwischen die Steuerelektrode des elektronischen Schalters (25) und Bezugspotential geschalteten Widerstand (27) besteht.

3. Schaltungsanordnung nach Anspruch 2, **dadurch gekennzeichnet,** daß dem Widerstand (23) des Zeitgliedes eine Diode (26) derart parallel geschaltet ist, daß ihre Kathode mit dem Ausgang der Komparatorschaltung (20) verbunden ist.

## Claims

1. A circuit arrangement for protecting against overload transistorised push-pull end stage (1,2) to the output of which a load impedance (3) to reference potential is connected, in which a sensor element (4,5) is provided in each branch of the push-pull end stage, characterised in that two voltages opposite in phase with respect to the reference potential can be tapped off on the sensor elements (4,5), and the voltages positive with respect to the reference potential are applied to the non-inverting input and the voltages negative with respect to the reference voltage are applied to the inverting input of a differential amplifier stage (10), and that the output of the differential amplifier stage (10) is connected to the non-inverting input (+) of a comparator circuit (20) to the inverting input (-) of which a reference voltage (Uref) formed with respect to the reference potential is applied, and that when the reference potential (Uref) is exceeded at the non-inverting input (+) of the comparator circuit (20) a signal for blocking the push-pull end stage (1,2) can be taken off at the output of that circuit, and when that stage is overloaded the output signal of the comparator circuit (20), by way of timing means (23,24,27) and an electronic switch controlled by these, switches the inverting input (-) of the comparator circuit (20) to the reference potential, and the output signal of the comparator circuit (20) is applied to the input of the push-pull end stage (1,2).

2. A circuit arrangement according to Claim 1, characterised in that the timing means consist of a series circuit which is connected between the output of the comparator circuit (20) and the control electrode of the electronic switch (25), and that this series circuit has a resistance (23) and a condenser (24) and a resistance (27) connected between the control electrode of the electronic switch (25) and reference potential.

3. A circuit arrangement according to Claim 2, characterised in that a diode (26) is connected in parallel with the resistance of the timing means in such a manner that the cathode of the diode is connected to the output of the comparator circuit.

**Revendications**

1. Montage pour la protection contre les surcharges d'un étage final push-pull transistorisé (1, 2), dont la sortie est reliée à une impédance de charge (3) suivant un potentiel de référence, un capteur (4, 5) étant prévu dans chaque branche de l'étage final push-pull, caractérisé en ce qu'il est possible de prélever au niveau des capteurs (4, 5) deux tensions en opposition de phase par rapport au potentiel de référence, les tensions positives par rapport au potentiel de référence étant appliquées à l'entrée non inverseur et les tensions négatives par rapport au potentiel de référence a l'entrée inverseur d'un étage amplificateur différentiel (10), et que la sortie de l'étage amplificateur différentiel (10) est reliée à l'entrée non inverseur (+) d'un circuit comparateur (20), dont l'entrée inverseur (-) reçoit une tension de référence (Uref) formée par rapport au potentiel de référence, et qu'en cas de dépassement du potentiel de référence (Uref) à l'entrée non inverseur (+) du circuit comparateur (20) il est possible de prélever à sa sortie un signal pour bloquer l'étage final push-pull (1, 2), qu'en cas de sa surcharge le signal de sortie du comparateur (20) commute par un organe de temps (23), 24, 27) et un commutateur électronique (25) commandé par ce dernier, l'entrée inverseur (-) du circuit comparateur (20) sur potentiel de référence, et le signal de sortie du circuit comparateur (20) est appliqué a l'entrée de l'étage final push-pull (1, 2).

2. Montage selon la revendication 1, caractérisé en ce que l'organe de temps se trouvant entre la sortie du circuit comparateur (20) et l'électrode de commande du commutateur électronique (25) se compose d'un montage en série comprenant une résistance (23) avec un condensateur (24) et une résistance (27) montée entre l'électrode de commande du commutateur électronique (25) et le potentiel de référence.

3. Montage selon la revendication 1, caractérisé en ce qu'une diode (26) est montée en parallèle à la résistance (23) de l'organe de temps de manière que sa cathode est reliée à la sortie du circuit comparateur (20).

EP 0 247 399 B1